# EUROPEAN PATENT APPLICATION

(11) **EP 4 832 049 A1**
(43) Date of publication of application: **28.10.2026**
(21) Application number: 24912657.4
(22) Date of filing: 20.12.2024
(51) Int. Cl.: H01L 21/301, B23K 26/53

(54) **PROTECTIVE FILM COMPOSITION FOR DICING, WAFER MANUFACTURING METHOD, AND WAFER PROCESSING METHOD**

(30) Priority: 28.12.2023 JP 2023222778
(71) Applicant: TOKYO OHKA KOGYO CO., LTD., Kawasaki-shi, Kanagawa 211 0012 (JP)
(72) Inventor: OKUBO, Asuka, Kawasaki-shi, Kanagawa 211-0012 (JP); KINOSHITA, Tetsuro, Kawasaki-shi, Kanagawa 211-0012 (JP)
(74) Representative: Plasseraud IP
(86) International application number: PCT/JP2024/045138
(87) International publication number: WO 2025/142768

(57) **Abstract**

Provided are a protective film composition for dicing, containing an ultraviolet absorber containing a compound (1) represented by the following General Formula (1), a water-soluble resin, formate ions, and water, in which a content of the formate ions is 300 to 6000 ppm by mass, and a method for manufacturing a wafer and a method for processing a wafer using the protective film composition for dicing.

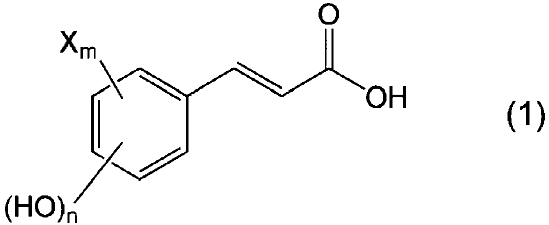

In the formula, X represents a hydrogen atom or -OR¹. R¹ represents a substituted or unsubstituted alkyl group having 1 to 5 carbon atoms. n represents a number of 1 to 5, and m represents a number of 0 to 4.

## Description

### Technical Field

The present invention relates to a protective film composition for dicing, a method for manufacturing a wafer, and a method for processing a wafer.

### Background Art

A wafer formed in a semiconductor device manufacturing process is obtained by partitioning, by grid-like planned dividing lines called streets, a laminate in which an insulating film and a functional film are laminated on a surface of a semiconductor substrate such as silicon, and each region partitioned by the streets serves as a semiconductor chip such as an IC or an LSI. That is, a plurality of semiconductor chips are obtained by processing and cutting the wafer along the streets.

Processing and cutting of a wafer are performed by, for example, laser dicing or the like. When laser dicing is performed, a protective film for dicing is provided on a surface of a wafer in order to prevent attachment of debris. As a technique relating to such a protective film for dicing, for example, Patent Literature 1 discloses a protective film agent for laser dicing consisting of a solution in which a water-soluble resin and at least one water-soluble laser light absorber selected from the group consisting of a water-soluble dye, a water-soluble colorant, and a water-soluble ultraviolet absorber are dissolved.

### Patent Literature

Patent Literature 1: JP 2006-140311 A

### Summary of Invention

### Technical Problem

As described above, a protective film for dicing prevents attachment of debris generated during dicing, but there is still room for improvement in the performance of the protective film for dicing.

First, some compositions for forming a protective film for dicing (protective film compositions for dicing) are blended with an absorber that absorbs laser light used during dicing, but there is a problem in that absorbance decreases over time as storage days pass. When absorbance decreases unintentionally, cutting with highly accurate laser light along a street line may become impossible, or laser processing with a uniform line width may become difficult.

Next, after a wafer protected by a protective film for dicing is cut by laser dicing, the protective film for dicing is removed by cleaning. In recent years, in order to produce precise structures, defect management on a substrate has become stricter, and therefore surface defects after cleaning of the protective film are also required to be improved more than ever. However, conventional protective film compositions for dicing have had a problem in that, as the compositions age, the amount of residue remaining after substrate cleaning increases.

The present invention has been made in view of the above circumstances, and a main object of the present invention is to provide a protective film composition for dicing that can suppress a decrease in absorbance over time and can suppress an increase in the number of defects over time, and a method for manufacturing a wafer and a method for processing a wafer using the protective film composition for dicing.

### Solution to Problem

As a result of intensive studies to achieve the above-described object, the present inventors obtained the finding of providing a protective film composition for dicing that contains an ultraviolet absorber containing a compound (1) having a specific structure, a water-soluble resin, formate ions, and water, and in which a content of the formate ions is 300 to 6000 ppm by mass, and have completed the present invention.

That is, the present invention is as follows.
<1> A protective film composition for dicing, containing: an ultraviolet absorber containing a compound (1) represented by the following General Formula (1); a water-soluble resin; formate ions; and water, in which a content of the formate ions is 300 to 6000 ppm by mass. 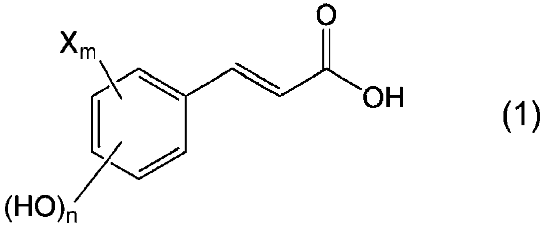 In the formula, X represents a hydrogen atom or -OR¹. R¹ represents a substituted or unsubstituted alkyl group having 1 to 5 carbon atoms. n represents a number of 1 to 5, and m represents a number of 0 to 4.
<2> The protective film composition for dicing according to <1>, in which the ultraviolet absorber is at least one selected from the group consisting of ferulic acid, 2-hydroxycinnamic acid, 4-hydroxycinnamic acid, 2,3-dihydroxycinnamic acid, and 3,4-dihydroxycinnamic acid.
<3> The protective film composition for dicing according to <1> or <2>, in which the water-soluble resin is at least one resin selected from the group consisting of a resin (2a) including a structural unit represented by the following Formula (2a-1) and a structural unit represented by the following Formula (2a-2), and a resin (2b) including a structural unit represented by the following Formula (2b). 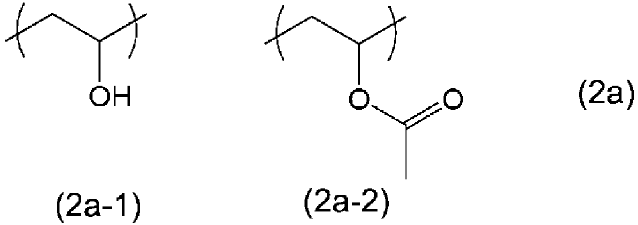 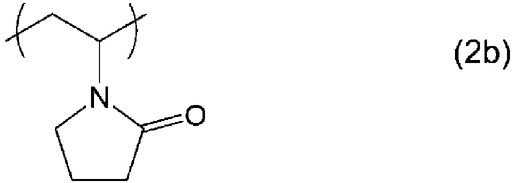
<4> The protective film composition for dicing according to any one of <1> to <3>, further containing a water-based organic solvent.
<5> The protective film composition for dicing according to <4>, in which the water-based organic solvent is at least one selected from the group consisting of a glycol-based solvent and an alcohol-based solvent.
<6> The protective film composition for dicing according to <4> or <5>, in which the protective film composition for dicing contains two or more water-based organic solvents as the water-based organic solvent.
<7> The protective film composition for dicing according to any one of <1> to <6>, in which a solid content concentration is 1% to 90% by mass.
<8> A method for manufacturing a wafer, the method including: a film formation step of applying the protective film composition for dicing according to any one of <1> to <7> to a processing surface of a wafer to form a protective film; and a processing step of irradiating the processing surface with laser light through the protective film to perform processing.
<9> The method for manufacturing a wafer according to <8>, in which a plurality of semiconductor chips partitioned by streets formed in a lattice shape are formed on the wafer, and the processing step is a step of forming grooves by irradiating the streets with laser light through the protective film.
<10> The method for manufacturing a wafer according to <8> or <9>, the method further including, after the processing step, a step of removing the protective film by water washing.
<11> A method for processing a wafer, the method including: a film formation step of applying the protective film composition for dicing according to any one of <1> to <7> to a processing surface of a wafer to form a protective film; and a processing step of irradiating the processing surface with laser light through the protective film to perform processing.

### Advantageous Effects of Invention

According to the present invention, the protective film composition for dicing that can suppress a decrease in absorbance over time and can suppress an increase in the number of defects over time, and a method for manufacturing a wafer and a method for processing a wafer using the protective film composition for dicing can be provided.

### Description of Embodiments

Hereinafter, modes for carrying out the present invention (hereinafter simply referred to as "the present embodiment") will be described in detail. The following present embodiment is an example for describing the present invention, and is not intended to limit the present invention to the following contents. The present invention can be implemented with appropriate modifications within the scope of the gist of the present invention. In addition, each configuration and parameter disclosed in the present specification can be used in any combination unless otherwise specified. Furthermore, upper limits and lower limits of values disclosed in the present specification can be used in any combination unless otherwise specified.

### <Protective Film Composition for Dicing>

The protective film composition for dicing according to the present embodiment is a protective film composition for dicing that contains an ultraviolet absorber containing a compound (1) represented by the following General Formula (1), a water-soluble resin, formate ions, and water, and in which a content of the formate ions is 300 to 6000 ppm by mass. 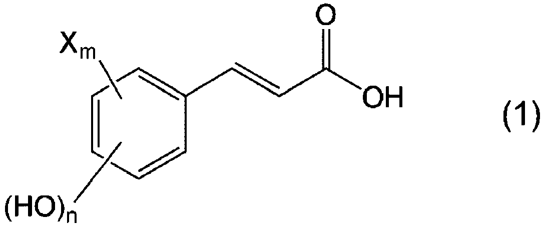 (In the formula, X represents a hydrogen atom or -OR¹. R¹ represents a substituted or unsubstituted alkyl group having 1 to 5 carbon atoms. n represents a number of 1 to 5, and m represents a number of 0 to 4.)

By controlling the content of the formate ions while including an ultraviolet absorber having the structure of General Formula (1) and a water-soluble resin, at least a decrease in absorbance over time can be suppressed, and an increase in the number of defects over time can be suppressed. For example, when absorbance fluctuates, an absorption wavelength changes; in the protective film composition for dicing according to the present embodiment, controlling the content of the formate ions also enables suppression of such a defect. In addition, after laser dicing, when debris is washed and removed with water or the like, debris adhering to a surface of a wafer may remain without being completely removed by cleaning, and such residual debris may cause the number of defects to increase over time; the protective film composition for dicing according to the present embodiment can suppress such a defect.

Hereinafter, various components and the like of the protective film composition for dicing according to the present embodiment will be described.

### (Ultraviolet Absorber)

A compound (1) has the structure of General Formula (1). The hydroxy group (-OH) of General Formula (1) may be present in a dissociated state in the composition, which is a solution. In addition, the compound (1) may be blended as a salt thereof. The kind of a salt of the compound (1) is not particularly limited, but from the viewpoints of water solubility, compatibility with other components, and the like, may be at least one selected from the group consisting of alkali metal salts (lithium salt, sodium salt, potassium salt, and the like) and hydrates thereof. By using the compound (1) having such a structure, film peeling during laser processing can be suppressed, and therefore attachment of debris can be effectively prevented. For example, when laser light is applied, thermal decomposition of a substrate progresses before thermal decomposition of a protective film, and a gap is formed between the protective film and a peripheral portion of a chip surface (near a street line) by the pressure of silicon vapor or the like, which is a thermal decomposition product thereof (that is, partial peeling of the protective film occurs at the peripheral portion), and as a result, attachment of debris to the peripheral portion of the chip surface is considered to occur. In this regard, according to the present embodiment, such attachment of debris can be effectively suppressed by using the above compound (1) in combination with a water-soluble resin, formate ions in a specific content, and the like.

The hydroxy group (-OH) bonded to the benzene ring of the compound (1) is preferably present at a para position and/or an ortho position with respect to an acrylic acid group (-C=C-COOH). When two or more hydroxy groups are present, at least one or more of the hydroxy groups are preferably present at a para position and/or an ortho position. Such a structure facilitates formation of a resonance structure or a dimer capable of effectively suppressing a decrease in absorbance over time (however, the actions and effects according to the present embodiment are not limited thereto).

X in General Formula (1) may be either a hydrogen atom or -OR¹, but is preferably a hydrogen atom.

When X in General Formula (1) is -OR¹, R¹ is a substituted or unsubstituted alkyl group having 1 to 5 carbon atoms. A lower limit of the number of carbon atoms may be 2 or more. An upper limit of the number of carbon atoms may be 4 or less.

Examples of the substituent in a case where R¹ is a substituted alkyl group (an alkyl group having a substituent) may include a halogen atom (a chloro group, a bromo group, an iodo group, and the like), a hydroxy group, a carbonyl group, a carboxy group, a nitro group, an amino group, a sulfo group, and the like.

Examples of the alkyl group in a case where R¹ is a substituted or unsubstituted alkyl group may include a methyl group, an ethyl group, an n-propyl group, an isopropyl group, an n-butyl group, an isobutyl group, an n-pentyl group, an isopentyl group, a tert-pentyl group, and the like. Among these, a methyl group is preferred. A preferred example in a case where X is -OR¹ may include, for example, a methoxy group (-OCH₃).

n is a number of 1 to 5, preferably 1 to 4, more preferably 1 to 3, and still more preferably 1 or 2.

m is a number of 0 to 4, but when X is an -OR¹ group, m is preferably 0 to 3, more preferably 0 to 2, and still more preferably 0 or 1. When all Xs are hydrogen atoms, n + m = 5 is preferred.

As the structure of General Formula (1), X is preferably an alkoxy group (for example, a methoxy group or the like), n is preferably 1 or 2, m is preferably 4 or 3, and n + m = 5 is preferred. Such a structure can suppress film peeling during laser processing, and therefore attachment of debris can be prevented more effectively.

In addition, a preferred example of the kind of ultraviolet absorber is at least one selected from the group consisting of ferulic acid, 2-hydroxycinnamic acid, 4-hydroxycinnamic acid, 2,3-dihydroxycinnamic acid, and 3,4-dihydroxycinnamic acid. Such a compound can suppress film peeling during laser processing, and therefore attachment of debris can be prevented more effectively.

The ultraviolet absorber may be used alone as one kind, or two or more kinds may be used in combination.

The content of the ultraviolet absorber in the protective film composition for dicing according to the present embodiment is not particularly limited as long as the content is within a range that does not inhibit the purpose of the present embodiment, but the content is preferably 1 to 10 parts by mass relative to 100 parts by mass of the water-soluble resin in the protective film composition for dicing. A lower limit of the content of the ultraviolet absorber relative to 100 parts by mass of the water-soluble resin in the protective film composition for dicing is more preferably 1.5 parts by mass or more, and still more preferably 2 parts by mass or more. In addition, an upper limit of the content of the ultraviolet absorber relative to 100 parts by mass of the water-soluble resin in the protective film composition for dicing is more preferably 8 parts by mass or less, and still more preferably 7 parts by mass or less.

### (Water-Soluble Resin)

The protective film composition contains a water-soluble resin. By dissolving the water-soluble resin in a solvent such as water or an aqueous medium, followed by application and drying, a protective film can be effectively formed. In addition, for example, after predetermined processing such as laser processing including laser ablation is performed, the protective film can also be easily removed by water washing.

The term "water-soluble" of the water-soluble resin in the present specification means, unless otherwise specified, that 0.5 g or more of a solute (the resin) dissolves relative to 100 g of water at 25°C. The water-soluble resin also includes a resin solubilized in water by being subjected to a hydrolysis reaction or treatment with a base in an aqueous medium. For example, as a result of being subjected to such reaction or treatment, a resin in which 0.5 g or more of a solute (the resin) can dissolve relative to 100 g of water at 25°C also corresponds to the "water-soluble resin" in the present specification.

A protective film for dicing formed on a wafer surface is usually removed from the wafer surface by water washing at an appropriate time after formation of processing grooves. For this reason, from the viewpoint of water washability of the protective film for dicing, the water-soluble resin is preferably a water-soluble resin having high affinity with water. From such a viewpoint, preferred examples of the water-soluble resin preferably include at least one selected from the group consisting of a vinyl-based resin, a polyvinyl alcohol-based resin, and a cellulose-based resin, and more preferably include at least one selected from the group consisting of a vinyl-based resin and a polyvinyl alcohol-based resin.

The weight average molecular weight of the water-soluble resin is not particularly limited, but is usually preferably 100 to 300000. A lower limit of the weight average molecular weight is more preferably 1000 or more, and still more preferably 10000 or more. In addition, an upper limit of the weight average molecular weight is more preferably 200000 or less, and still more preferably 150000 or less. Unless otherwise specified, the weight average molecular weight in the present specification refers to a weight average molecular weight (M_{w}) in terms of polystyrene, obtained by gel permeation chromatography (GPC) analysis.

The kind of water-soluble resin is not particularly limited, but is preferably at least one selected from the group consisting of a polyvinyl alcohol-based resin, a vinyl-based resin, and a cellulose-based resin. Such a water-soluble resin has not only high water solubility but also high compatibility with other components in the protective film composition for dicing, and therefore changes in absorbance over time and changes in the number of defects over time can be suppressed more effectively.

Specific examples of the polyvinyl alcohol-based resin may include, for example, polyvinyl alcohol (PVA), polyvinyl acetal (also including a vinyl acetate copolymer), a butenediol-vinyl alcohol copolymer, a polyvinyl alcohol-polyacrylic acid block copolymer, a polyvinyl alcohol-polyacrylic acid ester block copolymer, and the like. Among these, polyvinyl alcohol is preferred.

The vinyl-based resin is preferably a homopolymer of a monomer having a vinyl group or a copolymer of a monomer having a vinyl group, and is preferably a water-soluble resin. Specific examples of the vinyl-based resin may include, for example, at least one selected from the group consisting of a polyvinyl alcohol-based resin, poly-N-vinylacetamide, polyvinylpyrrolidone (PVP), polyacrylamide, poly(N-alkylacrylamide), polyallylamine, poly(N-alkylallylamine), partially amidated polyallylamine, poly(diallylamine), an allylamine-diallylamine copolymer, polyacrylic acid, and the like.

The cellulose-based resin is cellulose or a cellulose derivative, and preferably has water solubility. Examples of the cellulose derivative may include cellulose modified with an alkyl group (for example, a methyl group, an ethyl group, or the like), cellulose modified with a hydroxyalkyl group (for example, a hydroxymethyl group, a hydroxyethyl group, a hydroxypropyl group, or the like), and the like. Specific examples of the cellulose derivative may include at least one selected from the group consisting of methyl cellulose, ethyl cellulose, hydroxymethyl cellulose, hydroxyethyl cellulose, hydroxypropyl cellulose, and the like.

In addition, the structure of the water-soluble resin is preferably at least one resin selected from the group consisting of a resin (2a) including a structural unit represented by the following Formula (2a-1) and a structural unit represented by the following Formula (2a-2), and a resin (2b) including a structural unit represented by the following Formula (2b). These resins have a functional group having high affinity with water in a structural unit, and have not only high water solubility but also high compatibility with other components in the protective film composition for dicing, and therefore changes in absorbance over time and changes in the number of defects over time can be suppressed more effectively.

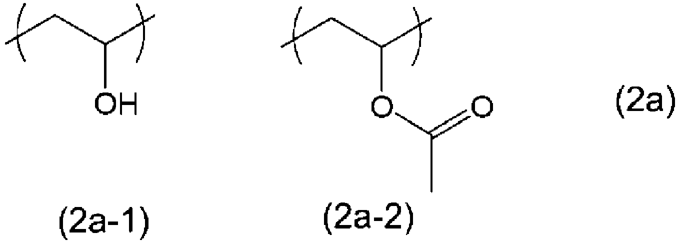

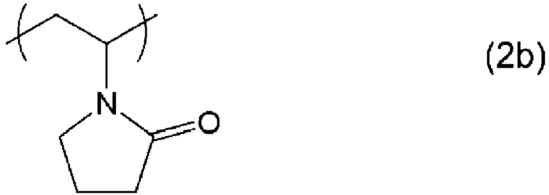

The water-soluble resin may be used alone as one kind, or two or more kinds may be used in combination. Preferred examples of a case where two or more kinds are used in combination may include, for example, a case of containing at least two kinds selected from the group consisting of a polyvinyl alcohol-based resin, a vinyl-based resin, and a cellulose-based resin. In addition, the various resins described above can be used. In addition, for example, an example of a case where two or more kinds of a polyvinyl alcohol-based resin and a vinyl-based resin are used in combination may include a case where a polyvinyl alcohol-based resin and a vinyl-based resin are contained. A blending ratio (mass ratio) in a case where a polyvinyl alcohol-based resin and a vinyl-based resin are contained is not particularly limited, but polyvinyl alcohol:vinyl-based resin may be 10:90 to 90:10, or may be 20:80 to 80:20.

### (Formate Ions)

The protective film composition for dicing according to the present embodiment contains formate ions, and a content of the formate ions is 300 to 6000 ppm by mass. A lower limit of the content of the formate ions is, for example, from the viewpoint of suppressing an increase in defects, preferably 300 ppm by mass or more, but may be 400 ppm by mass or more, or may be 350 ppm by mass or more. In addition, an upper limit of the content is, for example, from the viewpoint of stability over time, preferably 6000 ppm by mass or less, but may be 5900 ppm by mass or less, or may be 5950 ppm by mass or less. The increase in defects described above may be a factor that deteriorates electrical characteristics, and being able to suppress the increase in defects is also preferable in terms of being able to effectively suppress such deterioration of electrical characteristics. A method for controlling the content of the formate ions is not particularly limited, but, for example, a method of adding formic acid, a salt thereof, another derivative thereof, or the like may be used.

### (Additives and the Like)

The protective film composition for dicing according to the present embodiment may contain another known additive as necessary. Examples of the other additive may include a basic compound, a dye, a colorant, a plasticizer, a preservative, a surfactant, and various other additives.

### (Basic Compound)

The protective film composition for dicing according to the present embodiment may contain a basic compound for the purpose of facilitating dissolution of the solid content. As the basic compound, either an inorganic compound or an organic compound can be used.

Specific examples of the basic compound may include, for example, sodium hydroxide, potassium hydroxide, sodium carbonate, potassium carbonate, sodium silicate, sodium metasilicate, ammonia, ethylamine, n-propylamine, monoethanolamine, diethylamine, di-n-propylamine, diethanolamine, triethylamine, methyldiethylamine, dimethylethanolamine, triethanolamine, tetramethylammonium hydroxide, tetraethylammonium hydroxide, pyrrole, piperidine, 1,8-diazabicyclo[5,4,0]-7-undecene, 1,5-diazabicyclo[4,3,0]-5-nonane, and the like.

### (Dye)

The dye is preferably a water-soluble dye. Specific examples of the water-soluble dye may include, for example, azo dyes (monoazo and polyazo dyes, metal complex salt azo dyes, pyrazolone azo dyes, stilbene azo dyes, and thiazole azo dyes), anthraquinone dyes (anthraquinone derivatives and anthrone derivatives), indigoid dyes (indigoid derivatives and thioindigoid derivatives), phthalocyanine dyes, carbonium dyes (diphenylmethane dyes, triphenylmethane dyes, xanthene dyes, and acridine dyes), quinone imine dyes (azine dyes, oxazine dyes, and thiazine dyes), methine dyes (cyanine dyes and azomethine dyes), quinoline dyes, nitroso dyes, benzoquinone dyes, naphthoquinone dyes, naphthalimide dyes, perinone dyes, other dyes, and the like.

### (Colorant)

The colorant is preferably a water-soluble colorant. Specific examples of the water-soluble colorant may include food additive colorants such as Food Red No. 2, Food Red No. 40, Food Red No. 102, Food Red No. 104, Food Red No. 105, Food Red No. 106, Food Yellow NY, Food Yellow No. 4 tartrazine, Food Yellow No. 5, Food Yellow No. 5 Sunset Yellow FCF, Food Orange AM, Food Vermilion No. 1, Food Vermilion No. 4, Food Vermilion No. 101, Food Blue No. 1, Food Blue No. 2, Food Green No. 3, Food Melon Color B, Food Egg Color No. 3, and the like. Food additive colorants are preferable from the viewpoint of low environmental burden and the like.

### (Plasticizer)

By using the plasticizer, generation of cracks in the protective film can be suppressed more effectively, and flexibility, elasticity, laser processability, and the like of the protective film can be improved more effectively. Specific examples of the plasticizer may include, for example, monosaccharides, disaccharides, and the like.

### (Preservative)

From the viewpoint of further improving a preservative effect of the protective film composition for dicing according to the present embodiment and further reducing a treatment load for waste liquid after semiconductor wafer cleaning, a preservative is preferably used.

### (Surfactant)

The surfactant is used, for example, to enhance defoaming properties during production of the protective film composition for dicing, stability of the protective film composition for dicing, coatability of the protective film composition for dicing, and the like. From the viewpoint of defoaming properties during production of the protective film composition for dicing, a surfactant may be used. As the surfactant, a water-soluble surfactant can be preferably used. Examples of the surfactant may include a nonionic surfactant, a cationic surfactant, an anionic surfactant, an amphoteric surfactant, and the like.

The protective film is formed, for example, by spin-coating the protective film composition for dicing. However, when the protective film is formed, irregularities caused by bubbles may occur. In order to suppress occurrence of such irregularities, an antifoaming agent such as a surfactant can be used.

### (Water, Organic Solvent)

The protective film composition for dicing according to the present embodiment contains water from the viewpoint of dissolving the above-described solid components and from the viewpoint of removing the protective film for dicing by water washing. As the water, pure water, ultrapure water (DIW), deionized water, distilled water, purified water, or the like can be used.

In addition, the protective film composition for dicing according to the present embodiment preferably further contains a water-based organic solvent as necessary. The solvent is more preferably a mixed solvent containing water and a water-based organic solvent.

The water-based organic solvent is not particularly limited, but is preferably one or more selected from the group consisting of a glycol-based solvent, an alcohol-based solvent, a ketone-based solvent, a lactone-based solvent, an ester-based solvent, a sulfonic acid-based solvent, an amide-based solvent, and a pyrrolidone-based solvent, and more preferably one or more selected from the group consisting of a glycol-based solvent and an alcohol-based solvent.

Examples of the glycol-based solvent may include glycols, a glycol ether-based solvent, a glycol ester-based solvent, and the like.

Specific examples of the glycols may include ethylene glycol, diethylene glycol, propylene glycol, dipropylene glycol, glycerin, 1,3-propanediol, 1,3-butanediol, 1,4-butanediol, furfuryl alcohol, hexylene glycol, and the like.

Specific examples of the glycol ether-based solvent may include an alkylene glycol monoalkyl ether, an alkylene glycol dialkyl ether, a polymer-type polyalkylene glycol ether-based solvent, and the like.

Examples of the alkylene glycol monoalkyl ether may include ethylene-based glycol monoalkyl ethers such as ethylene glycol monomethyl ether, diethylene glycol monomethyl ether, triethylene glycol monomethyl ether, ethylene glycol monoethyl ether, ethylene glycol monobutyl ether, diethylene glycol monobutyl ether, triethylene glycol monobutyl ether, ethylene glycol monohexyl ether, and diethylene glycol monohexyl ether; propylene-based glycol monoalkyl ethers such as propylene glycol monomethyl ether (PGME), propylene glycol monoethyl ether, propylene glycol monopropyl ether, propylene glycol monobutyl ether, dipropylene glycol monomethyl ether (DPM), dipropylene glycol monoethyl ether, dipropylene glycol monopropyl ether, dipropylene glycol monobutyl ether, tripropylene glycol monomethyl ether, tripropylene glycol monoethyl ether, and tripropylene glycol monobutyl ether; and the like.

Examples of the alkylene glycol dialkyl ether may include ethylene-based glycol dialkyl ethers such as ethylene glycol dimethyl ether, diethylene glycol dimethyl ether, triethylene glycol dimethyl ether, ethylene glycol diethyl ether, ethylene glycol dibutyl ether, diethylene glycol dibutyl ether, triethylene glycol dibutyl ether, ethylene glycol dihexyl ether, and diethylene glycol dihexyl ether; propylene-based glycol dialkyl ethers such as propylene glycol dimethyl ether, propylene glycol diethyl ether, propylene glycol dipropyl ether, propylene glycol dibutyl ether, dipropylene glycol dimethyl ether, dipropylene glycol diethyl ether, dipropylene glycol dipropyl ether, dipropylene glycol dibutyl ether, tripropylene glycol dimethyl ether, tripropylene glycol diethyl ether, and tripropylene glycol dibutyl ether; and the like.

Examples of the polyalkylene glycol ether may include polyalkylene glycol ethers such as polyoxypropylene butyl ether, polyoxyethylene polyoxypropylene butyl ether, polyoxyethylene oleyl ether, and polyoxyethylene polyoxypropylene-2-ethylhexyl ether, and the like.

Among these, an ethylene-based glycol monoalkyl ether, a propylene-based glycol monoalkyl ether, an ethylene-based glycol dialkyl ether, a propylene-based glycol dialkyl ether, and the like are preferred, and propylene glycol monomethyl ether (PGME) and the like are more preferred.

Specific examples of the glycol ester-based solvent may include an alkylene glycol monoalkyl ether acetate and the like.

As the alkylene glycol monoalkyl ether acetate, examples may include ethylene-based glycol ether acetates such as ethylene glycol monobutyl ether acetate and diethylene glycol monobutyl ether acetate; propylene-based glycol ether acetates such as propylene glycol monomethyl ether acetate (PGMEA), dipropylene glycol monomethyl ether acetate, and propylene glycol diacetate; and the like.

Among these, ethylene-based glycol ether acetates and propylene-based glycol ether acetates are preferred, and propylene glycol monomethyl ether acetate (PGMEA) and the like are more preferred.

Specific examples of the alcohol-based solvent may include, for example, aliphatic alcohols such as methanol, ethanol, denatured ethanol, isopropanol, n-propanol, n-butanol, and 3-methoxy-3-methyl-1-butanol, and the like.

Specific examples of the ketone-based solvent may include acetone, methyl ethyl ketone (MEK), methyl isobutyl ketone (MIBK), diisobutyl ketone, cyclohexanone, cyclopentanone, diacetone alcohol, 1-hexanone, 2-hexanone, 4-heptanone, 2-heptanone, 1-octanone, 2-octanone, 1-nonanone, 2-nonanone, acetylacetone, acetonylacetone, phenylacetone, acetophenone, methyl naphthyl ketone, methylcyclohexanone, ionone, isophorone, propylene carbonate, diacetonyl alcohol, acetylcarbinol, and the like.

Specific examples of the lactone-based solvent may include γ-butyrolactone, α-methyl-γ-butyrolactone, β-propiolactone, γ-valerolactone, δ-valerolactone, γ-caprolactone, ε-caprolactone, γ-laurolactone, hexanolactone, and the like.

Specific examples of the ester-based solvent may include methyl acetate, ethyl acetate, butyl acetate, amyl acetate, propyl acetate, isopropyl acetate, methyl lactate, ethyl lactate, butyl lactate, ethyl methoxyacetate, ethyl ethoxyacetate, 2-methoxybutyl acetate, 3-methoxybutyl acetate, 4-methoxybutyl acetate, 3-methoxy-3-methylbutyl acetate, 3-ethyl-3-methoxybutyl acetate, 4-methyl-4-methoxypentyl acetate, ethyl lactate, propyl lactate, butyl lactate, and the like.

Specific examples of the sulfonic acid-based solvent may include, for example, dimethyl sulfone, diethyl sulfone, tetramethylene sulfone, dipropyl sulfone, sulfolane (also known as tetramethylene sulfone), 3-methylsulfolane, 2,4-dimethylsulfolane, 3,4-dimethylsulfolane, diphenylsulfolane, 3,4-diphenylmethylsulfolane, sulfolene, 3-methylsulfolene, 3-ethylsulfolene, and the like.

Specific examples of the amide-based solvent may include, for example, N,N-dimethylformamide (DMF), diethylformamide (DEF), N,N-dimethylacetamide (DMAc), N-methylpyrrolidine (MPD), hexamethylphosphoric triamide (HMPA), and the like.

Specific examples of the pyrrolidone-based solvent may include, for example, N-methylpyrrolidone (NMP), 2-pyrrolidone, N-vinyl-2-pyrrolidone, and the like.

The protective film composition for dicing according to the present embodiment may contain one kind of the above-described water-based organic solvent or may contain two or more kinds thereof, but preferably contains two or more water-based organic solvents. As a preferred example in a case where two or more water-based organic solvents are contained, two or more kinds of the above-described organic solvents can be selected.

As one example of a combination in a mixed solvent of water and the water-based organic solvent, the mixed solvent is preferably a mixed solvent including water and at least one selected from the group consisting of a glycol-based solvent and an alcohol-based solvent; more preferably a mixed solvent including water and at least one selected from the group consisting of a glycol ether-based solvent, a glycol ester-based solvent, and an alcohol-based solvent; still more preferably a mixed solvent including water and at least one selected from the group consisting of propylene glycol monomethyl ether (PGME), methanol, ethanol, denatured ethanol, isopropanol, n-propanol, n-butanol, and 3-methoxy-3-methyl-1-butanol; and even still more preferably a mixed solvent including water and propylene glycol monomethyl ether (PGME).

A mixing ratio of water and the water-based organic solvent in the mixed solvent of water and the water-based organic solvent is not particularly limited, but the content of water in 100 parts by mass of the total amount of water and the water-based organic solvent is preferably 30 to 99 parts by mass. A lower limit of the content of water is more preferably 40 parts by mass or more, still more preferably 50 parts by mass or more, even still more preferably 60 parts by mass or more, and yet even still more preferably 70 parts by mass or more. In addition, an upper limit of the content of water is more preferably 95 parts by mass or less, and still more preferably 90 parts by mass or less.

### (Solid Content Concentration)

The solid content concentration in the protective film composition for dicing according to the present embodiment is not particularly limited, but is preferably 1% to 90% by mass. A lower limit of the solid content concentration is more preferably 5% by mass or more, and still more preferably 10% by mass or more. In addition, an upper limit of the solid content concentration is more preferably 80% by mass or less, still more preferably 60% by mass or less, even still more preferably 40% by mass or less, and yet even still more preferably 30% by mass or less. In measurement of the solid content concentration, components excluding the solvent (water, organic solvent, and the like) from the total amount of the protective film composition for dicing are defined as the "solid content". The "solid content concentration" is a ratio of the total amount of components other than the solvent contained in the protective film composition for dicing to the total amount of the protective film composition for dicing (total amount of components other than the solvent contained in the protective film composition for dicing/total amount of the protective film composition for dicing (% by mass)).

### <Method for Manufacturing Wafer and Method for Processing Wafer>

According to the present embodiment, a wafer can be manufactured by applying the above-described protective film composition for dicing onto a substrate or the like to be protected to form a protective film (protective film for dicing), and then performing dicing. Such a method for manufacturing a wafer is preferably a method for manufacturing a wafer, including a film formation step of applying the above-described protective film composition for dicing to a processing surface of a wafer to form a protective film, and a processing step of irradiating the processing surface with laser light through the protective film to perform processing. Furthermore, the method more preferably includes, after the processing step, a step of removing the protective film by water washing.

In addition, according to the present embodiment, it is also suitable as a method for processing a wafer using the above-described protective film composition for dicing. Such a method for processing a wafer is preferably a method for processing a wafer, the method including a film formation step of applying the above-described protective film composition for dicing to form a protective film, and a processing step of irradiating a processing surface with laser light through the protective film to perform processing.

The method of application in the film formation step is not particularly limited, and spin coating, spray coating, die coating, roll coating, flow coating, curtain coating, or the like can be adopted according to the shape, material, and the like of the substrate, but application by spin coating is preferred. Furthermore, after application, post-treatment such as a drying step such as natural drying or hot-air drying, or a light irradiation step such as ultraviolet irradiation may be performed.

In a case where application is performed by spin coating, for example, (a) a step of applying the protective film composition for dicing to an application target (such as a semiconductor wafer) fixed on a stage of a spin coater (discharge step), (b) a step of rotating the stage to remove excess protective film composition for dicing by centrifugal force and form a thin film (rotation treatment step), and (c) a step of removing a workpiece from the spin coater and producing a thin film by natural drying, hot-air drying, or the like (drying step) are performed. Spin coating is preferable because spin coating has advantages such as being capable of film formation with little film thickness deviation and being excellent in film formation cost and film formation speed because spin coating can be performed even without a vacuum.

The film thickness of the protective film is not particularly limited, but is usually preferably 0.1 to 100 µm from the viewpoints of facilitating removal of the protective film by water washing after processing, ensuring durability of the protective film against irradiation with laser light described later, and the like. A lower limit of the film thickness is more preferably 1 µm or more, and still more preferably 3 µm or more. In addition, an upper limit of the film thickness is more preferably 50 µm or less, still more preferably 30 µm or less, even still more preferably 20 µm or less, and yet even still more preferably 10 µm or less. In this regard, for example, when the protective film is formed by spin coating, film formation having excellent film formability and selectivity can be more effectively performed for a film thickness in the above range.

In the processing step, laser dicing in which laser light is applied to the processing surface is preferably performed. Laser dicing can perform processing without contacting the wafer to be processed, and therefore defects such as cracks and chipping can be effectively suppressed. Specifically, a plurality of semiconductor chips partitioned by streets formed in a lattice shape are formed on the wafer, and the processing step is more preferably a step of forming grooves by irradiating the streets with laser light through the protective film. The grooves become processing grooves having a pattern corresponding to the shape of the semiconductor chips.

According to the protective film composition for dicing and the protective film according to the present embodiment, film formability, straightness of the processing groove (straightness of side walls of the protective film constituting the processing groove), and rectangularity of a cross section of the processing groove (rectangularity of a cross section of the protective film constituting the processing groove) are expected to be favorable. Excellent processability enables accurate processing without deviation from a desired position, and therefore processing with higher positional accuracy is also possible.

From the viewpoint of intensity, the laser light is preferably an ultraviolet laser having a wavelength of 100 to 400 nm. In addition, the laser light is preferably a YVO4 laser or a YAG laser having a wavelength of 266 nm, 355 nm, or the like.

The above laser light irradiation in the processing groove formation step can be performed, for example, under the following processing conditions. The focused spot diameter can be appropriately selected in consideration of the width of the processing groove.
Light source of laser light: YVO4 laser or YAG laser
Wavelength of laser light: 355 nm
Repetition frequency of laser light: 50 to 100 kHz
Output of laser light: 0.1 to 4.0 W
Processing feed speed of laser light: 1 to 800 mm/sec

Then, after laser light is applied along a predetermined street, the semiconductor wafer held on a chuck table can be indexed and moved by the interval between the streets, and laser light can be applied again. In this way, after irradiation with laser light and indexing movement are performed for all streets extending in a predetermined direction, the semiconductor wafer held on the chuck table is rotated by 90 degrees. Then, irradiation with laser light and indexing movement are performed in the same manner as described above along each street extending perpendicular to the predetermined direction. In this way, processing grooves can be formed along the streets formed in the laminate on the semiconductor wafer.

Furthermore, a cutting step of cutting at positions of the processing grooves provided on the processing surface of the wafer (positions corresponding to the positions of the streets) may be performed. When the cutting step is performed, the method is suitable as a method for manufacturing semiconductor chips.

After the dicing step is performed, the protective film covering the surfaces of the semiconductor chips is removed. Since the protective film composition for dicing according to the present embodiment contains the water-soluble resin, the protective film can be efficiently washed away with water.

An example of the method for manufacturing a semiconductor wafer and the method for processing a semiconductor wafer has been described above. According to the above method according to the present embodiment, use of the protective film formed from the protective film composition for dicing according to the present embodiment enables debris to be effectively washed and removed by cleaning after dicing. The method is particularly suitable when cleaning is performed with water. Since the protective film composition for dicing according to the present embodiment contains the predetermined ultraviolet absorber and the water-soluble resin, and the content of the formate ions is controlled to be a predetermined ratio, peeling or loss of the protective film formed on the wafer can be effectively suppressed. In addition, a decrease in absorbance over time can be suppressed, and an increase in the number of defects over time can also be suppressed. Therefore, unintended peeling of the protective film during laser processing can also be effectively suppressed. Examples

The present invention will be described in more detail by the following Examples and Comparative Examples, but the present invention is not limited in any way by the following Examples. Unless otherwise specified below, quantities are on a mass basis, and experiments were conducted under conditions of 25°C and atmospheric pressure.

### <Components>

A list of components used in Examples and Comparative Examples is shown.
- PVA: polyvinyl alcohol (saponification degree: 75%, manufactured by Kuraray Co., Ltd., "Poval (registered trademark) PVA5-74LLA")
- PVP: polyvinylpyrrolidone (manufactured by Dai-ichi Kogyo Seiyaku Co., Ltd., "PVP K90")
- Ferulic acid
- Water: DIW (ultrapure water)
- PGME: propylene glycol monomethyl ether
- Formate ions: formic acid was added to achieve a predetermined formate ion concentration.

### <Preparation of Protective Film Composition for Dicing>

The components were mixed to obtain the respective compositions shown in Table 1, thereby preparing protective film compositions for dicing (hereinafter sometimes referred to as "chemical liquids"). The solid content concentration in Table 1 refers to the concentration of components excluding the solvent among the components contained in the obtained chemical liquid. For example, Example 1 was a liquid protective film composition for dicing containing 100 parts by mass of PVA and 5 parts by mass of ferulic acid, and dissolved in a mixed solvent in which the mixing ratio of water and PGME (water/PGME) was 80:20 by mass so that the solid content concentration was 20% by mass, and the content of the formate ions was 6000 ppm by mass. In addition, for example, Example 13 was a liquid protective film composition for dicing containing 100 parts by mass of a resin in which the mixing ratio of PVA and PVP (PVA/PVP) was 50:50 by mass and 5 parts by mass of ferulic acid, and dissolved in a mixed solvent in which the mixing ratio of water and PGME (water/PGME) was 80:20 by mass so that the solid content concentration was 15% by mass, and the content of the formate ions was 2000 ppm by mass.

### (Measurement of Solid Content Concentration)

The solid content concentration was defined as the total amount of components other than the solvent contained in the "chemical liquid"/the total amount of the "chemical liquid" (% by mass).

### (Measurement of Formate Ions)

Formate ions in the protective film composition for dicing were quantified by ion chromatography.

### <Evaluation of Absorbance>

The chemical liquids of the respective Examples and Comparative Examples were stored in polyethylene tanks for predetermined periods (initial, two weeks, and one month) in an environment at 40°C and shielded from light. Then, the absorbance was evaluated using a gram absorptivity coefficient (unit: L/g·cm) with an ultraviolet-visible spectrophotometer (UV-vis).

### <Evaluation of Number of Defects>

First, the chemical liquids of the respective Examples and Comparative Examples were applied to surfaces of silicon substrates (12-inch Si substrates) using a spinner under conditions of 2000 rpm for 120 seconds. Thereafter, natural drying was performed at room temperature for 10 minutes to form protective films having a film thickness of 1 µm.

Subsequently, the protective film was rinsed with water using pure water for 300 seconds and then dried.

A wafer defect inspection apparatus (manufactured by KLA-Tencor Corporation, "Surfscan SP5") was used to count the number of pieces of foreign matter having a maximum major diameter greater than 300 nm, and the count was defined as the number of defects. The measurement was performed immediately after preparation of the chemical liquid ("initial"), after one week had elapsed from preparation of the chemical liquid ("1W"), and after one month had elapsed from preparation of the chemical liquid ("1M"). Then, the number of defects of Example 1 at "initial" (immediately after preparation) was taken as a reference value "1", and the number of defects of each Example and each Comparative Example was determined as a relative ratio thereto. When the value of "1M (after one month had elapsed)" could be suppressed to 3 times or less the value of "initial" of Example 1, the sample was determined to be "A" (pass) because characteristics sufficient to withstand practical use could be expected from the viewpoint of electrical characteristics and the like.

For example, in the case of Example 2, the number of defects at "initial" was 1.1 times the number of defects of Example 1 at "initial", the number of defects at "2W (after two weeks had elapsed)" was 1.2 times the "initial" of Example 1, and the number of defects at "1M (after one month had elapsed)" was 1.3 times the "initial" of Example 1, indicating that the determination was "A" (pass).

For example, in the case of Comparative Example 1, the number of defects at "initial" was 1.3 times the number of defects of Example 1 at "initial", the number of defects at "2W (after two weeks had elapsed)" was 2.2 times the "initial" of Example 1, and the number of defects at "1M (after one month had elapsed)" was 3.2 times the "initial" of Example 1, indicating that the determination was "B" (fail).

The composition of each Example and each Comparative Example is shown in Table 1, and the evaluation result of each Example and each Comparative Example is shown in Table 2.

**[Table 1]**

| | Resin | (parts by mass ) | Absorber | (parts by mass ) | Solvent (mass ratio) | Solid content concentration (% by mass) | Formate ions (ppm by mass) |
|---|---|---|---|---|---|---|---|
| Example 1 | PVA | 100 | Ferulic acid | 5 | Water/PGME=80/20 | 20% | 6000 |
| Example 2 | PVA | 100 | Ferulic acid | 5 | Water/PGME=80/20 | 20% | 2000 |
| Example 3 | PVA | 100 | Ferulic acid | 5 | Water/PGME=80/20 | 20% | 1000 |
| Example 4 | PVA | 100 | Ferulic acid | 5 | Water/PGME=80/20 | 20% | 300 |
| Example 5 | PVP | 100 | Ferulic acid | 5 | Water/PGME=80/20 | 6% | 6000 |
| Example 6 | PVP | 100 | Ferulic acid | 5 | Water/PGME=80/20 | 6% | 2000 |
| Example 7 | PVP | 100 | Ferulic acid | 5 | Water/PGME=80/20 | 6% | 1000 |
| Example 8 | PVP | 100 | Ferulic acid | 5 | Water/PGME=80/20 | 6% | 300 |
| Example 9 | PVA | 100 | Ferulic acid | 5 | Water/PGME=90/10 | 20% | 2000 |
| Example 10 | PVA | 100 | Ferulic acid | 5 | Water/PGME=70/30 | 20% | 2000 |
| Example 11 | PVP | 100 | Ferulic acid | 5 | Water/PGME=90/10 | 6% | 2000 |
| Example 12 | PVP | 100 | Ferulic acid | 5 | Water/PGME=70/30 | 6% | 2000 |
| Example 13 | PVA/PVP=50:50 | 100 | Ferulic acid | 5 | Water/PGME=80/20 | 15% | 2000 |
| Example 14 | PVA/PVP=70:30 | 100 | Ferulic acid | 5 | Water/PGME=80/20 | 18% | 2000 |
| Example 15 | PVA/PVP=30:70 | 100 | Ferulic acid | 5 | Water/PGME=80/20 | 10% | 2000 |
| Comparative Example 1 | PVA | 100 | Ferulic acid | 5 | Water/PGME=80/20 | 20% | 0 |
| Comparative Example 2 | PVA | 100 | Ferulic acid | 5 | Water/PGME=80/20 | 20% | 10000 |
| Comparative Example 3 | PVP | 100 | Ferulic acid | 5 | Water/PGME=80/20 | 6% | 0 |
| Comparative Example 4 | PVP | 100 | Ferulic acid | 5 | Water/PGME=80/20 | 6% | 10000 |

**[Table 2]**

| | Absorbance change (gram absorptivity coefficient) | | | | Number of defects | | | |
|---|---|---|---|---|---|---|---|---|
| | Initial | 2 W | 1 M | Evaluation | Initial | 2 W | 1 M | Evaluation |
| Example 1 | 0.20 | 0.21 | 0.30 | A | 1 | 1.3 | 1.4 | A |
| Example 2 | 0.20 | 0.20 | 0.30 | A | 1.1 | 1.2 | 1.3 | A |
| Example 3 | 0.20 | 0.20 | 0.30 | A | 1 | 1.1 | 1.3 | A |
| Example 4 | 0.20 | 0.20 | 0.30 | A | 1.2 | 1.1 | 1.2 | A |
| Example 5 | 0.20 | 0.20 | 0.21 | A | 1.2 | 1.4 | 2.4 | A |
| Example 6 | 0.20 | 0.20 | 0.20 | A | 1.1 | 1.2 | 1.3 | A |
| Example 7 | 0.20 | 0.20 | 0.21 | A | 1 | 1.1 | 1.2 | A |
| Example 8 | 0.20 | 0.20 | 0.20 | A | 1.1 | 1 | 1.1 | A |
| Example 9 | 0.20 | 0.20 | 0.30 | A | 1 | 1.2 | 1.3 | A |
| Example 10 | 0.20 | 0.20 | 0.30 | A | 1.1 | 1.1 | 1.2 | A |
| Example 11 | 0.20 | 0.20 | 0.20 | A | 1 | 1.2 | 1.2 | A |
| Example 12 | 0.20 | 0.20 | 0.20 | A | 1.1 | 1.2 | 1.3 | A |
| Example 13 | 0.20 | 0.20 | 0.23 | A | 1.1 | 1.1 | 1.2 | A |
| Example 14 | 0.20 | 0.20 | 0.25 | A | 1 | 1.1 | 1.3 | A |
| Example 15 | 0.20 | 0.20 | 0.22 | A | 1.1 | 1.2 | 1.2 | A |
| Comparative Example 1 | 0.20 | 0.20 | 0.17 | B | 1.3 | 2.2 | 3.2 | B |
| Comparative Example 2 | 0.20 | 0.30 | 0.40 | A | 1.4 | 3.2 | 4.5 | B |
| Comparative Example 3 | 0.20 | 0.20 | 0.17 | B | 1.3 | 2.4 | 3.8 | B |
| Comparative Example 4 | 0.20 | 0.30 | 0.50 | A | 1.5 | 2.9 | 3.6 | B |

From the above, it was at least confirmed that the protective film composition for dicing according to the present Examples can suppress a decrease in absorbance over time and can suppress an increase in the number of defects over time.

The present application is based on Japanese Patent Application (Japanese Patent Application No. 2023-222778) filed with the Japan Patent Office on December 28, 2023, the contents of which are incorporated herein by reference.

## Claims

1. A protective film composition for dicing, comprising: an ultraviolet absorber containing a compound (1) represented by the following General Formula (1); a water-soluble resin; formate ions; and water, wherein
a content of the formate ions is 300 to 6000 ppm by mass, 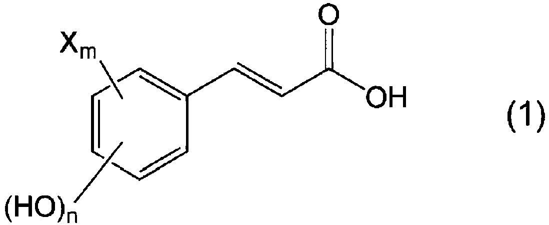
wherein X represents a hydrogen atom or -OR¹; R¹ represents a substituted or unsubstituted alkyl group having 1 to 5 carbon atoms; n represents a number of 1 to 5; and m represents a number of 0 to 4.

2. The protective film composition for dicing according to claim 1, wherein
the ultraviolet absorber is at least one selected from the group consisting of ferulic acid, 2-hydroxycinnamic acid, 4-hydroxycinnamic acid, 2,3-dihydroxycinnamic acid, and 3,4-dihydroxycinnamic acid.

3. The protective film composition for dicing according to claim 1, wherein
the water-soluble resin is at least one resin selected from the group consisting of a resin (2a) including a structural unit represented by the following Formula (2a-1) and a structural unit represented by the following Formula (2a-2), and a resin (2b) including a structural unit represented by the following Formula (2b).

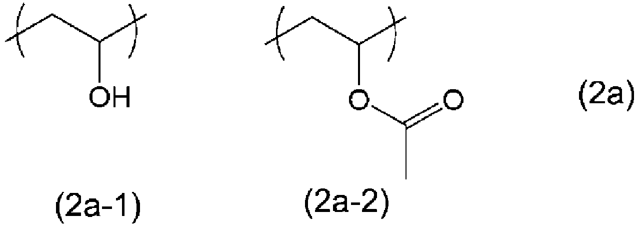

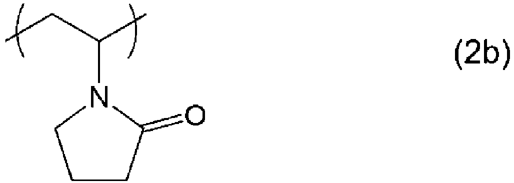

4. The protective film composition for dicing according to claim 1, further comprising
a water-based organic solvent.

5. The protective film composition for dicing according to claim 4, wherein
the water-based organic solvent is at least one selected from the group consisting of a glycol-based solvent and an alcohol-based solvent.

6. The protective film composition for dicing according to claim 5, wherein
the protective film composition for dicing contains two or more water-based organic solvents as the water-based organic solvent.

7. The protective film composition for dicing according to claim 1, wherein
a solid content concentration is 1% to 90% by mass.

8. A method for manufacturing a wafer, the method comprising:
a film formation step of applying the protective film composition for dicing according to claim 1 to a processing surface of a wafer to form a protective film; and
a processing step of irradiating the processing surface with laser light through the protective film to perform processing.

9. The method for manufacturing a wafer according to claim 8, wherein
a plurality of semiconductor chips partitioned by streets formed in a lattice shape are formed on the wafer, and
the processing step is a step of forming grooves by irradiating the streets with laser light through the protective film.

10. The method for manufacturing a wafer according to claim 8, the method further comprising,
after the processing step, a step of removing the protective film by water washing.

11. A method for processing a wafer, the method comprising:
a film formation step of applying the protective film composition for dicing according to claim 1 to a processing surface of a wafer to form a protective film; and
a processing step of irradiating the processing surface with laser light through the protective film to perform processing.
